# EUROPÄISCHE PATENTSCHRIFT

(11) **EP 1 309 014 B1**
(45) Veröffentlichungstag und Bekanntmachung des Hinweises auf die Patenterteilung: **26.11.2008**
(21) Anmeldenummer: 01811059.3
(22) Anmeldetag: 31.10.2001
(51) Int. Cl.: H01L 39/16

(54) **Resistiver supraleitender Strombegrenzer**
Superconducting resistive current limiter
Limiteur de courant résistif à supraconducteur

(43) Veröffentlichungstag der Anmeldung: 07.05.2003
(73) Patentinhaber: ABB Research Ltd., 8050 Zürich (CH)
(72) Erfinder: Chen, Makan, 5405 Baden-Dättwil (CH); Paul, Willi, 5430 Wettingen (CH); Lakner, Martin, 5413 Birmenstorf (CH); Rhyner, Jakob, 8006 Zürich (CH)
(74) Vertreter: ABB Patent Attorneys

(56) Entgegenhaltungen:
- DE-A- 19 832 274
- DE-C- 19 827 225
- JP-A- 2000 032 654
- PATENT ABSTRACTS OF JAPAN vol. 018, no. 008 (E-1486), 7. Januar 1994 (1994-01-07) & JP 05 251757 A (MITSUBISHI ELECTRIC CORP), 28. September 1993 (1993-09-28) -& JP 05 251757 A (MITSUBISHI ELECTRIC CORP) 28. September 1993 (1993-09-28)
- PATENT ABSTRACTS OF JAPAN vol. 017, no. 672 (E-1474), 10. Dezember 1993 (1993-12-10) & JP 05 226707 A (MITSUBISHI ELECTRIC CORP), 3. September 1993 (1993-09-03) -& JP 05 226707 A (MITSUBISHI ELECTRIC CORP) 3. September 1993 (1993-09-03)

## Beschreibung

### TECHNISCHES GEBIET

Die vorliegende Erfindung bezieht sich auf das Gebiet der angewandten Hochtemperatursupraleitung. Sie betrifft einen resistiven supraleitenden Strombegrenzer gemäss dem Oberbegriff des Patentanspruchs 1.

### STAND DER TECHNIK

Hochtemperatursupraleiter finden beispielsweise Verwendung in supraleitenden Kurzschluss-Strombegrenzem für elektrische Verteil- oder Übertragungsnetzwerke. Bei einem solchen Strombegrenzer wird ausgenutzt, dass ein Supraleiter bei einer entsprechend tiefen Betriebstemperatur seine Supraleitfähigkeit nur solange beibehält, als die Stromdichte eines ihn durchfliessenden Stromes unterhalb eines gewissen, als kritische Stromdichte bezeichneten Grenzwertes bleibt. Tritt im entsprechenden Stromversorgungsnetzwerk ein Kurzschluss auf, wächst der Strom im Strombegrenzer zu einem den kritischen Wert übertreffenden Fehlerstrom an. Als Folge davon tritt der Supraleiter in den resistiven Zustand über, d.h. die am entsprechenden Abschnitt des Stromversorgungsnetzwerkes anliegende Spannung fällt zumindest kurzzeitig ganz (im Kurzschlussfall) oder teilweise am Supraleiter ab.

In der Deutschen Offenlegungsschrift DE-A 197 46 976 ist eine Hochtemperatursupraleiteranordnung zur Verwendung in einem Strombegrenzer dargestellt. Die Anordnung umfasst eine supraleitende Schicht und eine als elektrischer Bypass ausgebildete, gelochte Stahlplatte, welche mit der supraleitenden Schicht einen Leiterverbund bildet. Die Supraleiteranordnung kann zusätzlich durch faserverstärkte Verbundwerkstoffe mechanisch stabilisiert und elektrisch isoliert werden und wird in ein flüssiges Kühlmedium, der Einfachheit halber vorzugsweise flüssigen Stickstoff (LN₂), welcher durch ein Kryostat genanntes Gefäss von der Umgebung thermisch isoliert ist, eingetaucht.

In der DE-A 198 32 274 ist ein resistiver Strombegrenzer mit einer Leiterbahnstruktur aus Hoch-T_{c} Supraleitermaterial auf einem elektrisch isolierenden Trägerkörper dargestellt. Gerade Leiterbahnabschnitte sind durch kreisringförmige, gebogene Abschnitte verbunden. Für Letztere soll ein maximales Radienverhältnis von rₐ/rᵢ = 7 eingehalten werden, wobei rᵢ der Innen- und rₐ der Aussenradius der Abschnitts ist. Damit wird vermieden, dass an Knickstellen der Leiterbahn mit zu kleinen Innenradien die Stromverteilung und damit die Wärmebelastung im Begrenzungsfall inhomogen wird. Durch den minimalen Innenradius wird die inhomogene lokale Belastung auf ein tolerierbares Mass gesenkt. Gleichzeitig wird aber die Flächenausnutzung, d.h. der prozentuale Anteil der durch die Leiterbahnstruktur überdeckten Trägerkörperoberfläche, verschlechtert, da bei einer konstanten Leiterbahnbreite bei den Umkehrpunkten zwischen aufeinanderfolgenden, annähernd parallelen, geraden Abschnitten diese untereinander einen gewissen seitlichen Mindestabstand einhalten müssen.
Der Abstract JP-A-05 251 757 zeigt einen supraleitenden Film in Mäanderform, bei welchem durch eine Verbreiterung der Leiterbahn im Bereich der Kehren die Stromdichte im Innenbereich der Kehren reduziert ist. Der Abstract JP-A-05 226 707 zeigt Leiterquerschnitte einer supraleitenden Leiterbahn, welche nicht rechteckförmig sind. Das Patent US 6,344,956 zeigt einen Supraleitenden Strombegrenzer, bei welchem im Bereich der Kehren die supraleitende Querschnittsfläche verbreitert und ein Bypasswiderstand aufgelötet ist.

### DARSTELLUNG DER ERFINDUNG

Aufgabe der vorliegenden Erfindung ist es, bei einem resistiven supraleitenden Strombegrenzer im Begrenzungsfall Stromdichteüberhöhungen in einem Eckelement zwischen zwei geraden Leiterbahnabschnitten zu vermindern. Diese Aufgabe wird durch einen resistiven supraleitenden Strombegrenzer mit den Merkmalen des Patentanspruchs 1 gelöst.
Kern der Erfindung ist es, den von einem Fehlerstrom im Begrenzungsfall im Eckelement durchflossenen Leiterquerschnitt senkrecht zur Hauptstromrichtung gegenüber dem entsprechenden Leiterquerschnitt der geraden Leiterstücke hinsichtlich Leitfähigkeit und/oder Geometrie anders auszubilden. Der angesprochene Leiterquerschnitt umfasst dabei sowohl den im Begrenzungsfall normalleitenden Hochtemperatursupraleiter wie auch den elektrischen Bypass. Die Modifikation dieses Leiterquerschnitts erfolgt zumindest lokal und braucht nicht über den ganzen Eckbereich uniform zu sein.

Zu Vergleichszwecken werden gedanklich die zwei geraden Leiterbahnabschnitte stetig differenzierbar durch eine kreisbogenförmige "kanonische Verbindung" verbunden. Letztere soll einen konstanten Leiterquerschnitt und, soweit möglich, einen minimalen Innenradius aufweisen und stellt in einem gewissen Sinne die naheliegendste oder bevorzugteste Verbindung der zwei geraden Leiterbahnabschnitte dar. Leiterbahnanteile des tatsächlichen Eckelements, welche nicht im Überschneidungsbereich mit dieser kanonischen Verbindung liegen, tragen wenig zur Leitung des Fehlerstroms bei, nur der durch den Innen- und Aussenradius der kanonischen Verbindung begrenzte Leiterbahnanteil des Eckelements wird betrachtet. Sein im Begrenzungsfall stromführender Leiterquerschnitt weicht erfindungsgemäss gegenüber demjenigen der geraden Leiterbahnabschnitte betreffend Geometrie und/oder elektrischer Leitfähigkeit ab, so dass, ohne Einbusse bei der Flächenausnutzung, der Fehlerstrom eine weniger abrupte Richtungsänderungen untergeht.
Gemäss einer ersten Ausführungsform wird die supraleitende Schicht im Überschneidungsbereich nicht verändert, die erfindungsgemässe Modifikation des Leiterquerschnittes erfolgt nur über den Bypass. Dadurch wird vermieden, dass durch eine, auf die Ausbildung der supraleitenden Schicht folgende, mechanische Bearbeitung derselben im Hochtemperatursupraleiter Risse erzeugt werden.
Vorteilhafterweise liegt dabei ein leitfähigkeitsgemittelter Schwerpunkt des modifizierten Leiterquerschnitts näher bei der Aussenkante der kanonischen Verbindung, so dass wiederum der effektive mittlere Radius des Eckelementes vergrössert und der Fehlerstrom somit eine weniger abrupte Richtungsänderung untergeht. Eine Beeinflussung des leitfähigkeitsgemittelten Schwerpunkts geschieht beispielsweise dadurch, dass der Bypass im Bereich der Innenkante verdünnt oder ganz abgetragen wird. Es ist auch möglich, die Dicke des Bypass entlang der Aussenkante durch Aufbau einer weiteren Bypassschicht zu erhöhen. Eine weitere Alternative, ohne Beeinflussung des geometrischen Schwerpunktes, basiert auf einem Zulegieren von Verunreinigungen zum Bypass im Bereich der Innenkante, wodurch dort sein elektrischer Widerstand erhöht wird.
Weitere vorteilhafte Ausführungsformen gehen aus den abhängigen Patentansprüchen hervor.

### KURZE BESCHREIBUNG DER FIGUREN

Nachfolgend wird die Erfindung anhand von Ausführungsbeispielen im Zusammenhang mit den Zeichnungen näher erläutert. Es zeigen
Fig.1 eine Verbindung unter 90° (a) und 180° (b) zweier gerader Leiterbahnabschnitte in Aufsicht, und
Fig.2 einen Schnitt durch die Verbindung gemäss Fig.1b) entlang der Linie AA, mit drei erfindungsgemässen Ausgestaltungen des elektrischen Bypass.

Die in den Zeichnungen verwendeten Bezugszeichen sind in der Bezugszeichenliste zusammengefasst. Grundsätzlich sind gleiche Teile mit denselben Bezugszeichen versehen.

### WEGE ZUR AUSFÜHRUNG DER ERFINDUNG

Resistive Strombegrenzer auf Hochtemperatursupraleiterbasis werden bevorzugt als flache Module mit einem elektrisch isolierenden Träger oder Substrat und beidseitig darauf aufgebrachten Leiterbahnen hergestellt. Letztere umfassen einen Leiterverbund aus dem Hochtemperatursupraleiter und einem metallischen elektrischen Bypass aus Ag und/oder Stahl. Im Nennbetrieb fliesst ein Nennstrom I_{N} durch den Supraleiter. Im Begrenzungsfall, d.h. wenn der Nennstrom über den kritischen Strom I_{C} des Supraleiters angewachsen ist und sich im Supraleiter ein Spannungsabfall ausbildet, übernimmt der Bypass einen überwiegenden Anteil des Fehlerstromes und entlastet damit den Supraleiter. Für die folgenden Betrachtungen wird davon ausgegangen, dass der Supraleiter eine erste Schicht und der Bypass eine auf dem Supraleiter aufgebrachte zweite Schicht bildet.

Die Leiterbahnen werden im Allgemeinen als fortlaufende oder rechteckspiralförmige Mäander ausgebildet und umfassen gerade Leiterbahnabschnitte, welche durch Ecken oder Kehren von 90° oder 180° miteinander verbunden sind. Während unterhalb der kritischen Temperatur T_{C} die Nichtlinearität der Strom-Spannungscharakteristik dafür sorgt, dass der Nennstrom jederzeit und überall einigermassen gleichförmig über den Leiterquerschnitt verteilt wird, ist im Begrenzungsfall bei den genannten Ecken oder Kehren eine inhomogene Stromverteilung zu erwarten. Eine Stromdichteüberhöhung an exponierten Stellen hat dort eine starke lokale Erwärmung der Leiterbahn zur Folge, durch die thermomechanische Belastung kann der Supraleiter beschädigt werden.

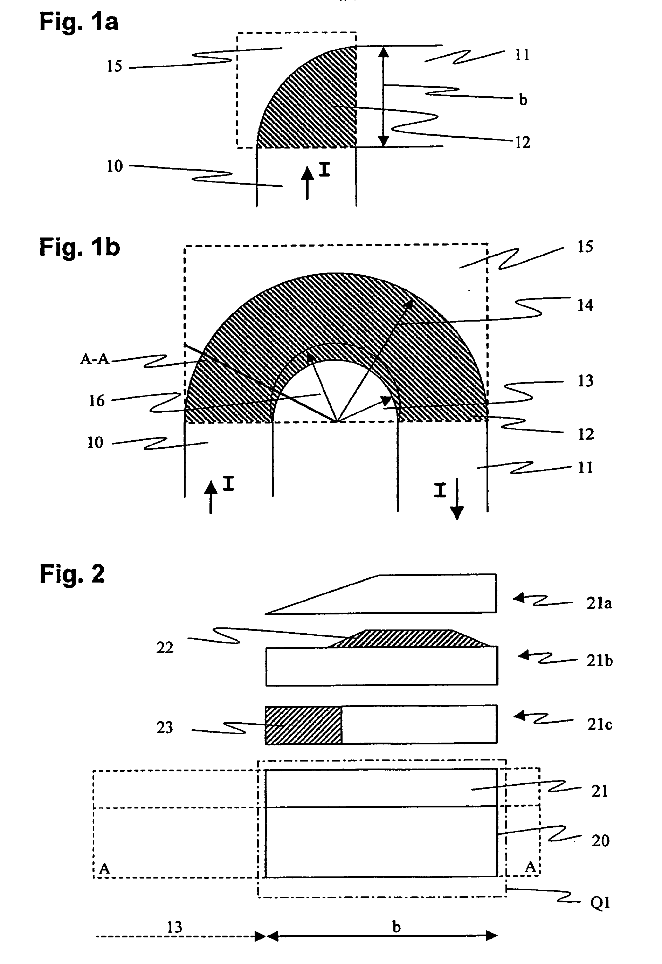

In Fig.1 sind die Enden zweier gerader Leiterbahnabschnitte 10,11 der Leiterbahnbreite b gezeigt, welche untereinander einen Winkel von 90° (Fig.1a) beziehungsweise 180° (Fig.1b einschliessen und in einer Hauptstromflussrichtung von einem Strom I durchflossen werden. Zum besseren Verständnis der Erfindung ist weiter die sogenannte kanonische Verbindung 12 zwischen den zwei geraden Leiterbahnabschnitten 10,11 schraffiert eingezeichnet. Diese bildet einen hypothetischen, perfekt kreisbogenförmigen Leiterbahnabschnitt der Leiterbahnbreite b. Falls die betroffenen Enden der beiden geraden Leiterbahnabschnitte 10,11 nicht von vorneherein festgelegt sind, kann der kanonische Innenradius 13 der kanonischen Verbindung 12 möglichst klein gewählt werden.

Die Ausdehnung eines Eckelementes 15 in der Ebene der Leiterbahnen, d.h. die laterale Ausbreitung der tatsächlichen Verbindung der beiden geraden Leiterbahnabschnitte 10,11, ist keineswegs auf den Bereich der kanonischen Verbindung 12 beschränkt. Die Erfindung betrachtet jedoch nur den Überschneidungsbereich, welcher die kanonische Verbindung 12 aus dem Eckelement 15 herausschneidet, und lässt die übrigen Bereiche, beispielsweise den inneren Halbkreis in Fig 1.b, ausser Betracht. Aus fertigungstechnischen Gründen ist es nämlich nicht unbedingt wünschbar, den tatsächlichen Eckbereich kreisbogenförmig auszugestalten, so dass die übrigen Bereiche nicht entfernt werden und zumindest als Wärmesenken noch wertvolle Dienste leisten.

Gemäss einer ersten Ausführungsform ist der tatsächliche Eckbereich 15 so ausgestaltet, dass ein effektiver Innenradius 16 des Leiterverbundes im Überschneidungsbereich grösser ist als der Innenradius 13 der kanonischen Verbindung 12. In der Aufsicht in Fig.1b) ist dieser effektive Innenradius 16 übertrieben dargestellt, denn die verbleibende Leiterbahnbreite im Überschneidungsbereich sollte lokal im Allgemeinen noch mindestens 90% der Leiterbahnbreite b betragen. Beträgt die Verringerung der Leiterbahnbreite jedoch mehr als 10%, ist es angebracht, die Dicke der Supraleitenden Schicht zu erhöhen, um eine signifikante Einbusse bei der Nennstromstärke I_{N} zu vermeiden. Vorteilhafterweise sind beim Übergang zwischen den geradlinigen Leiterbahnabschnitten 10,11 und dem Eckelement 15 die Innenkanten entsprechend etwas abgerundet.

Die Vergrösserung des Innenradius im Eckbereich erfolgt geeigneterweise gleichzeitig mit der Ausbildung der Leiterbahnstruktur, d.h. des Mäanders. Aus einer durchgehenden Schicht eines fertig präparierten Supraleiters wird das überflüssige Material mittels Wasserstrahlschneiden oder Lasern entfernt. Alternativ werden die gewünschten Strukturen erzeugt duch geeignete Abdeckungstechniken beim Auftragen beziehungsweise Aufwachsen dünner supraleitender Schichten auf einem Substrat oder Trägerkörper.

Fig.2 zeigt einen nicht massstäblichen Querschnitt entlang der Linie AA des Eckelementes 15 der Fig.1b. Auf einer supraleitenden Schicht 20 ist eine Bypassschicht 21 aufgebracht, wobei der die beiden Schichten unterstützende Trägerkörper nicht dargestellt ist. Derjenige Teil des Eckelementes 15, welcher nicht in den Überschneidungsbereich mit der kanonischen Verbindung 12 fällt, ist gestrichelt dargestellt. Die mit Q1 bezeichnete, strichpunktiert umrandete Fläche entspricht dem im Begrenzungsfall stromführenden Leiterquerschnitt Q1 der geraden Leiterbahnabschnitte. Allgemein sind die erwähnten Leiterquerschnitte immer senkrecht zur Hauptstromflussrichtung orientiert, d.h. transversal bei den geraden Leiterabschnitten 10,11 und radial bei der kanonischen Verbindung 12, also in der Schnittebene der Fig.2.

In dieser Ausführungsform wird der mittlere Weg des Fehlerstromes im Begrenzungsfall nur durch eine entsprechende Modifikation des Bypass im Eckbereich vergrössert. Entsprechende alternative Ausbildungen des Bypass 21 sind in Fig.2 mit ausgezogenen Linien oberhalb des im Begrenzungsfall stromführenden Leiterquerschnitt Q1 dargestellt. Der Supraleiter 20 ist für alle aufgeführten Fälle identisch und gleich demjenigen des unveränderten Leiterquerschnitts Q1. In der obersten Version ist der Bypass 21a innen dünner ausgeführt als aussen, wobei die Reduktion der Bypassschichtdicke bis zu einer vollständigen Entfernung des Bypassmaterials gehen kann. In der mittleren Version ist eine zweite Bypassschicht 22 mit einem grösseren Innenradius auf den ersten Bypass 21b aufgebracht. Die dritte Version zeichnet sich durch einen Legierungsbereich 23 mit erhöhtem spezifischem Widerstand entlang der Innenkannte des Bypass 21c aus. Durch die drei genannten Massnahmen wird der effektive minimale Radius des Eckelementes 15 vergrössert, je nach Leiterbahngeometrie bis zu einem Faktor 2 gegenüber dem kanonischen Innenradius 13. Infolge des Wegfalles der erwähnten Nichtlinearität der Strom-Spannungscharakteristik im Begrenzungsfall ist dieser effektive minimale Radius des Eckelementes 15 auch mehr oder weniger mit einem effektiven mittleren Radius im Eckbereich identisch.

Die zweite Bypassschicht 22 wird auf die erste Bypassschicht 21b mittels Flammenspritzen, elektrochemischer Deposition (Ag plating), Aufdampfen oder Auflöten aufgebracht. Alternativ wird Erstere geschaffen durch selektives Entfernen einer im Herstellungsprozess benötigten Metallfolie. Insbesondere kann ein derartiger zweiter Bypass 22 auch auf der anderen Seite des Supraleiters 20 zu liegen kommen. Typische Schichtdicken für zweite Bypassschichten aus Silber oder Kupfer betragen 100 um. Dadurch wird einerseits der elektrische Widerstand im äusseren Kehrenbereich herabgesetzt, so dass dort eine geringere Joul'sche Wärme zu erwarten ist, andererseits wird die Wegleitung dieser Wärme zu einem Kältereservoir oder zu anderen Bereichen des Anordnung verbessert.

Insbesondere im Fall von schmelzprozessiertem Bi₂Sr₂CaCu₂Oₓ Hochtemperatursupraleitermaterial wird in den vorgängig geschilderten Fällen der Bypass 21a,b,c vorteilhafterweise zuerst fertig strukturiert und anschliessend mit dem fertig prozessierten Supraleiter zusammengefügt. Letzteres geschieht unter Verkleben oder Verlöten ohne mechanische Belastung für den Supraleiter. Typische Leiterbahnbreiten b betragen dabei 20 mm, der seitliche Abstand (= 2^{.}rᵢ) zweier paralleler gerader Leiterbahnabschnitte eines fortlaufenden Mäanders beträgt weniger als 3 mm.

Die dargelegten Überlegungen gelten nicht nur für schmelzprozessiertes BSCCO, sondern auch für epitaktisches YBCO Schichtstrukturen und sogar für Drähte. Tatsächlich sind nämlich auch andere Geometrien möglich, beispielsweise kann der Supraleiter allseitig vom Bypass umgeben sein oder in einzelne, im Bypass eingebettete Filamente zerfallen. Im Weiteren tritt das Problem der Stromdichteüberhöhung, wenn auch in geringerem Mass, auch bei beliebig kleinen Richtungsänderungen zwischen zwei aufeinanderfolgenden geraden Leiterbahnabschnitten auf, so dass die hier vorgeschlagenen Lösungen keineswegs auf 90°- oder 180°-Kehren beschränkt sind.

### BEZUGSZEICHENLISTE

- 10: erster gerader Leiterbahnabschnitt
- 11: zweiter gerader Leiterbahnabschnitt
- 12: kanonische Verbindung
- 13: kanonischer Innenradius
- 14: kanonischer Aussenradius
- 15: Eckelement
- 16: effektiver Innenradius
- 20: supraleitende Schicht
- 21: Bypassschicht
- 22: zweite Bypassschicht
- 23: Legierungsbereich
- b: Leiterbahnbreite
- Q1: erster Leiterquerschnitt
- Q2: zweiter Leiterquerschnitt

## Patentansprüche

1. Resistiver supraleitender Strombegrenzer mit einer auf einem Träger aufgebrachten Leiterbahn aus einem Leiterverbund umfassend einen Hochtemperatursupraleiter und einen elektrischen Bypass, wobei
die Leiterbahn zwei geradlinige Leiterbahnabschnitte (10,11) der Leiterbahnbreite b und ein zwischen den zwei geradlinigen Leiterbahnabschnitten (10,11) angeordnetes Eckelement (15) umfasst,
die zwei geradlinigen Leiterbahnabschnitte (10,11) einen transversalen ersten Leiterquerschnitt Q 1 aufweisen,
das Eckelement (15) einen Kreisringabschnitt (12) mit einer gegenüber den geradlinigen Leiterbahnabschnitten (10,11) in der Dicke unveränderten supraleitenden Schicht (20) der Breite b umfasst, welcher die zwei geradlinigen Leiterbahnabschnitte (10,11) verbindet,
**dadurch gekennzeichnet, dass** der Kreisringabschnitt (12) lokal einen radialen zweiten Leiterquerschnitt aufweist, welcher vom ersten Leiterquerschnitt Q1 bezüglich Geometrie und/oder Leitfähigkeit verschieden ist.

2. Strombegrenzer nach Anspruch 1, **dadurch gekennzeichnet, dass** ein leitfähigkeitsgemittelter Schwerpunkt des zweiten Leiterquerschnittes lokal näher bei einem Aussenradius (14) als bei einem Innenradius (13) des Kreisringabschnittes (12) liegt.

3. Strombegrenzer nach Anspruch 2, **dadurch gekennzeichnet, dass** der Bypass (21) entlang dem Innenradius (13) dünner ausgebildet ist als entlang dem Aussenradius (14).

4. Strombegrenzer nach Anspruch 2, **dadurch gekennzeichnet, dass** auf dem Bypass (21) entlang dem Aussenradius (14) eine zweite Bypassschicht (22) aufgebracht ist.

5. Strombegrenzer nach Anspruch 2, **dadurch gekennzeichnet, dass** der Bypass (21) entlang dem Innenradius (13) legiert ist.

## Claims

1. Resistive superconducting current limiter having a conductor track which is applied to a mount, is composed of a conductor assembly and comprises a high-temperature superconductor and an electrical bypass, in which
the conductor track has two straight conductor track sections (10, 11) with a conductor track width b, and a corner element (15) arranged between the two straight conductor track sections (10, 11),
the two straight conductor track sections (10, 11) have a transverse first conductor cross section Q1,
the corner element (15) has a circular ring section (12) with a superconducting layer (20) of width b unchanged in thickness from the straight conductor track sections (10, 11), which connects the two straight conductor track sections (10, 11),
**characterized in that** the circular ring section (12) locally has a radial second conductor cross section which is different to the first conductor cross section Q1 in terms of geometry and/or conductivity.

2. Current limiter according to Claim 1, **characterized in that** a centroid, with average conductivity, of the second conductor cross section is locally closer to an outer radius (14) than to an inner radius (13) of the circular ring section (12).

3. Current limiter according to Claim 2, **characterized in that** the bypass (21) is designed to be thinner along the inner radius (13) than along the outer radius (14).

4. Current limiter according to Claim 2, **characterized in that** a second bypass layer (22) is applied on the bypass (21), along the outer radius (14).

5. Current limiter according to Claim 2, **characterized in that** the bypass (21) is alloyed along the inner radius (13).

## Revendications

1. Limiteur de courant résistif supraconducteur, qui présente une piste conductrice appliquée sur un support et constituée d'un composite conducteur qui comprend un supraconducteur à haute température et une dérivation électrique,
la piste conductrice comprenant deux tronçons rectilignes (10, 11) de piste conductrice d'une largeur b et un élément de coin (15) disposé entre les deux tronçons rectilignes (10, 11) de piste conductrice,
les deux tronçons rectilignes (10, 11) de piste conductrice présentant une première section transversale conductrice (Q1),
l'élément de coin (15) comprenant un tronçon (12) d'anneau circulaire qui comprend une couche supraconductrice (20) de largeur b dont l'épaisseur est identique à celle des tronçons rectilignes (10, 11) de la piste conductrice, ce tronçon d'anneau circulaire reliant les deux tronçons rectilignes (10, 11) de la piste conductrice,
**caractérisé en ce que**
le tronçon (12) en anneau circulaire présente localement une deuxième section transversale radiale conductrice dont la géométrie et/ou la conductivité est différente de celles de la première section transversale conductrice Q1.

2. Limiteur de courant selon la revendication 1, **caractérisé en ce que** le centre de gravité moyen de la conductivité de la deuxième section transversale conductrice est situé localement plus près du rayon extérieur (14) que du rayon intérieur (13) du tronçon (12) en anneau circulaire.

3. Limiteur de courant selon la revendication 2, **caractérisé en ce que** la dérivation (21) est plus mince le long du rayon intérieur (13) que le long du rayon extérieur (14).

4. Limiteur de courant selon la revendication 2, **caractérisé en ce que** le long du rayon extérieur (14), une deuxième couche de dérivation (22) est appliquée sur la dérivation (21).

5. Limiteur de courant selon la revendication 2, **caractérisé en ce que** la dérivation (21) est alliée le long du rayon intérieur (13).
